# DEMANDE DE BREVET EUROPEEN

(11) **EP 1 313 226 A1**
(43) Date de publication de la demande: **21.05.2003**
(21) Numéro de dépôt: 02292805.5
(22) Date de dépôt: 12.11.2002
(51) Int. Cl.: H04B 1/036, H05K 1/02

(54) **Dispositif de radiocommunication comprenant un systéme de dissipation thermique**

(30) Priorité: 16.11.2001 FR 0114866
(71) Demandeur: ALCATEL, 75008 Paris (FR)
(72) Inventeur: Danet, Olivier, 95520 Osny (FR); Le Quere, René, 95130 Le Plessis Bouchard (FR); Baro, Jose Marie, 95150 Taverny (FR)
(74) Mandataire: Sciaux, Edmond

(57) **Abrégé**

Dispositif de radiocommunication comprenant une antenne (20) et un amplificateur de puissance (24) relié à un circuit imprimé (26), caractérisé en ce que la masse (21) de l'antenne (20) et la masse (22) de l'amplificateur de puissance (24) sont reliées thermiquement.

## Description

La présente invention concerne un dispositif de radiocommunication comprenant une antenne et un circuit imprimé reliés à un amplificateur de puissance.

Un des domaines d'application, non exclusif, de l'invention est celui des terminaux mobiles de radiocommunication fonctionnant dans un système de radiocommunication cellulaire. L'invention s'applique notamment, mais non exclusivement, à un système selon les standards GSM (Groupe spécial Systèmes Mobiles publics de radiocommunication) et GPRS (General Packet Radio Service).

Avec les évolutions technologiques des terminaux mobiles, la prise en considération des aspects thermiques liés aux amplificateurs de puissance devient inévitable car la densité de puissance dissipée est en augmentation et la durée de vie des terminaux en est affectée. En effet, les amplificateurs de puissance comportent plusieurs transistors ayant des jonctions avec le circuit imprimé gestionnaire de la mémoire du terminal mobile et ces jonctions sont soumises à des contraintes thermiques transitoires.

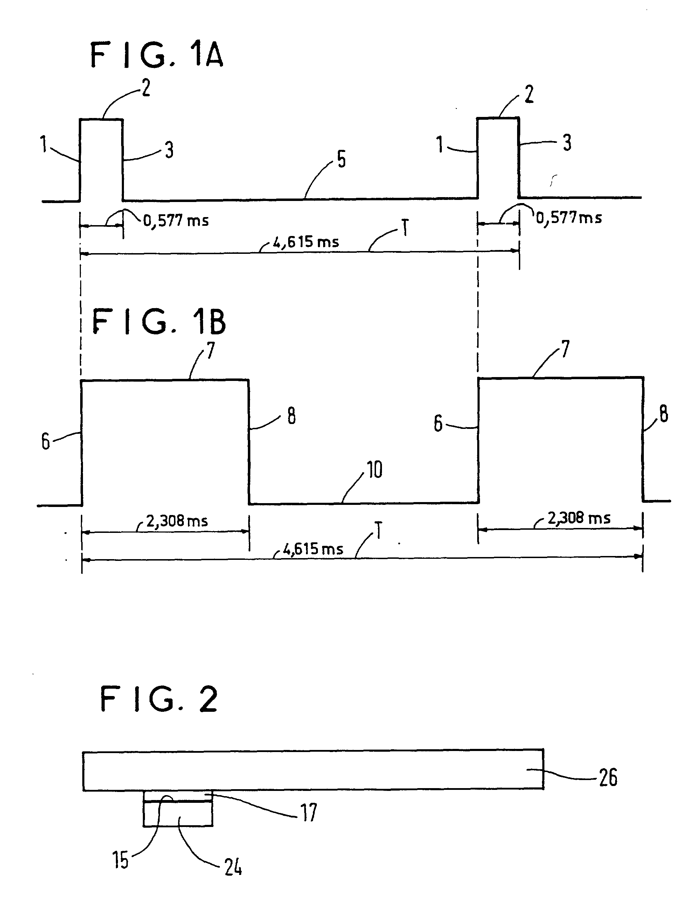

En effet, lors du fonctionnement du terminal, le signal RadioFréquence ( RF ) n'est émis ou reçu que pendant un temps déterminé avec une périodicité fixée par la l'horloge de référence du réseau, donc sous forme d'un signal variable en créneau, comme l'indiquent les figures 1a et 1b.

Dans le cas d'une utilisation du terminal dans un réseau GSM, dont le signal est représenté sur la figure 1a, les composants tels que les amplificateurs de puissance dissipent de la puissance par « effet Joule » vers le circuit imprimé et l'air pendant les phases de montée/ descente et maintien du signal RF, car leur rendement de conversion d'énergie est inférieur à 100%.

Ainsi du fait de cette puissance dissipée pendant le créneau, les amplificateurs de puissance sont soumis à un créneau de température.

Sur un temps plus long, la succession de créneaux se stabilise vers une température asymptotique qui peut être élevée.

La figure 1a illustre le fait que les amplificateurs de puissance sont soumis à un brusque saut de tension 1, puis à la fin du créneau 2 à une brusque chute de tension 3, suivie d'un temps de coupure 5.

Ainsi, ces composants sont soumis à une brusque montée en température, suivie d'un maintien à une température élevée, puis à une brusque chute de température.

Ces conditions de fonctionnement sont encore plus extrêmes pour les amplificateurs de puissance lors d'une utilisation du terminal dans un réseau GPRS, dont le signal est représenté sur la figure 1b, que dans un réseau GSM.

Ceci est illustré par la comparaison des figures 1a et 1b. La comparaison entre les deux signaux s'effectue sur une même période T de 4,615ms. Nous pouvons constater que le saut de tension 6 du signal GPRS est 1,5 fois plus grand que pour le saut de tension 1 du signal GSM.

Le créneau 7 du signal GPRS peut être 4 fois plus long que le créneau 2 du signal GSM, respectivement 2,308 ms contre 0,577ms et le temps de coupure 10 après la chute de tension 8 du signal GPRS plus court (réduit à 0.5*4.615ms) que le temps de coupure 5 après la chute de tension 3 du signal GSM.

Donc la température de jonction des transistors des amplificateurs de puissance est plus élevée pour une utilisation du terminal dans un réseau GARS que dans le réseau GSM.

Or, les limites en température imposées au semi-conducteur des amplificateurs de puissance, dont les températures maximum d'utilisation sont inégales en fonction de la nature du matériau utilisé (175°C maximum pour le Silicium, 150°C maximum pour l'Arséniure de Gallium), montrent qu'une augmentation de 25°C de la température de jonction du transistor de l'amplificateur de puissance avec le circuit imprimé peut doubler le nombre de panne. Dans notre exemple, la température passe de 35°C pour le réseau GSM à 50°C pour le réseau GPRS.
En particulier, l'action de la température se manifeste sur :
- les performances électriques de l'amplificateur de puissance par des phénomènes de dérive et d'emballement thermique,
- le comportement mécanique du boîtier de l'amplificateur de puissance (par exemple, un problème de brasures),
- les cycles thermiques (tensions liées aux différents coefficients de dilatation des différentes pièces composant l'amplificateur de puissance),
- la fiabilité de l'amplificateur de puissance.

Donc, l'utilisation du terminal en mode GPRS provoque un vieillissement prématuré des amplificateurs de puissance.

De plus, la tendance actuelle est d'intégrer les amplificateurs de puissance dans des boîtiers de plus en plus miniatures. Ainsi, le rapport de la puissance dissipée par la surface de l'amplificateur tend à augmenter.

Pour toutes ces raisons d'évolutions technologiques des terminaux mobiles, il est impératif de limiter l'élévation de la température des composants des terminaux, sous peine de diminuer notablement la durée de vie des terminaux.

Une solution de l'art antérieur, représentée en figure 2, est d'insérer entre le circuit imprimé 26 et la jonction 15 du transistor de l'amplificateur de puissance 24 avec le circuit imprimé 26 une plaque de cuivre 17. Cette plaque doit absorber une partie la puissance thermique dissipée par l'amplificateur de puissance 24.

Ceci induit une étape supplémentaire dans le procédé de fabrication, un coût de matériau plus important et un temps de qualification plus important, donc le prix de revient est trop cher, de plus, l'absorption de puissance thermique risque de se dégrader avec le temps.

L'invention a pour but de pallier ces inconvénients et de réaliser un terminal mobile moins cher, plus efficace et plus fiable, dont l'élévation en température de l'amplificateur de puissance est limitée.

En particulier, l'invention propose de dissiper une partie de la puissance thermique de l'amplificateur de puissance 24 à travers l'antenne 20 du dispositif.

L'invention, à cet effet, propose un dispositif de radiocommunication comprenant une antenne 20 et un amplificateur de puissance 24 reliés à un circuit imprimé 26, caractérisé en ce que la masse 21 de l'antenne 20 et la masse 22 de l'amplificateur de puissance 24 sont reliées thermiquement.

Selon un mode de réalisation, la masse 21 de l'antenne 20 est fixée entre la masse 22 de l'amplificateur de puissance 24 et le circuit imprimé 26.

Dans un autre mode de réalisation, la masse 21 de l'antenne 20 est fixée sur la face du circuit imprimé 26 opposé à la face sur laquelle est fixée la masse 22 de l'amplificateur de puissance 24.

Dans d'autres modes de réalisation, la masse 21 de l'antenne 20 est reliée thermiquement à la masse 22 de l'amplificateur de puissance 24 par des ponts thermiques, ou par des trous métallisés 32 traversant le circuit imprimé 26.

D'autres caractéristiques et avantages de l'invention apparaîtront à la lecture de la description suivante d'un mode de réalisation particulier de l'invention, donné à titre illustratif et pas limitatif, et des dessins énoncés ci-dessous.

Les figures 1a et 1b déjà décrites présentent la comparaison entre les deux signaux GSM et GPRS dans le préambule de la description.

La figure 2 déjà décrite illustre schématiquement un circuit imprimé comportant un amplificateur de puissance selon l'art antérieur.

La figure 3a illustre schématiquement en coupe un circuit imprimé comportant un amplificateur de puissance selon un premier mode de réalisation de l'invention.

La figure 3b illustre schématiquement en perspective cavalière un circuit imprimé comportant un amplificateur de puissance selon un premier mode de réalisation de l'invention.

La figure 4 illustre schématiquement un circuit imprimé comportant un amplificateur de puissance selon un deuxième mode de réalisation de l'invention.

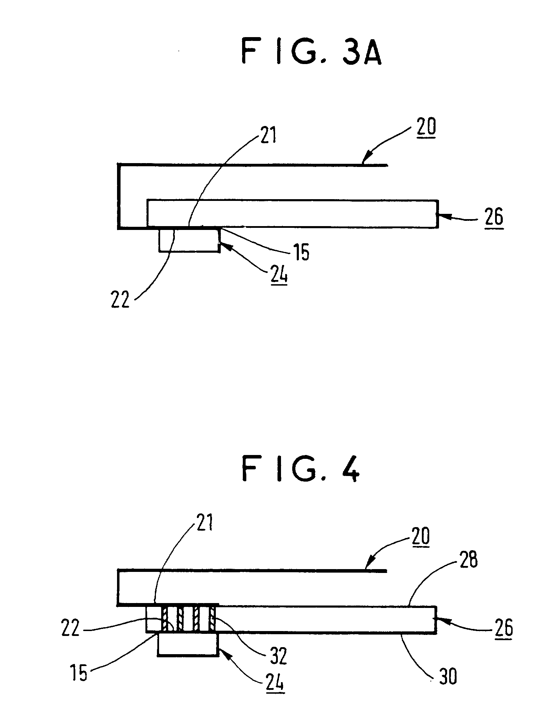

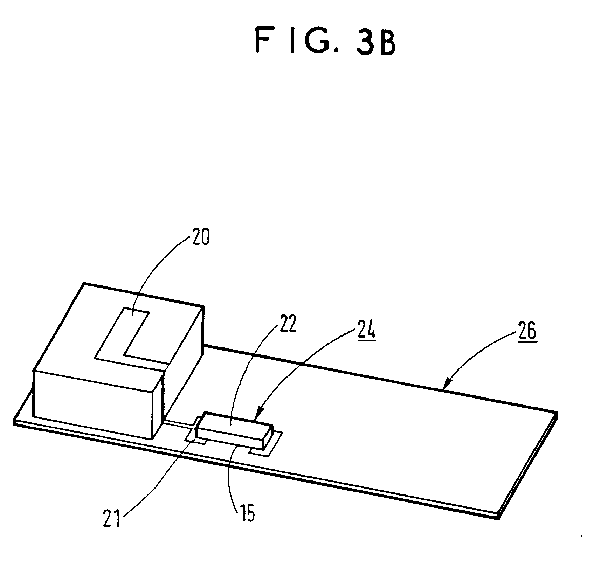

Les figures 3a et 3b montrent la fixation, par soudure par exemple, de la masse 21 de l'antenne 20 du terminal entre la masse 22 du transistor de l'amplificateur de puissance 24 et le circuit imprimé 26. L'antenne 20 représentée dans cet exemple est une antenne du type patch.

Ainsi, l'antenne 20 de grande surface peut dissiper très facilement la puissance thermique émise par l'amplificateur de puissance 24.

Ainsi, on obtient une diminution de la température car une partie de la puissance thermique peut être dissipée via l'antenne du terminal 20.

Or l'antenne 20 a une plus grande surface que celle de la jonction 15 du transistor avec le circuit imprimé 26. Donc elle peut dissiper beaucoup plus facilement la puissance thermique émise par l'amplificateur de puissance 24.

Donc, le point de fonctionnement de l'amplificateur de puissance 24 n'est pas modifié par un excès de température qui nuirait à son bon fonctionnement et provoquerait de nombreuses panes.

Cependant, en particulier pour une antenne de type patch, il est important de maintenir une cavité de résonance magnétique vide de tout élément étranger, d'où le deuxième mode de réalisation possible de l'invention dans le quel la cavité de l'antenne 20 ne comprend pas le circuit imprimé 26.

La figure 4 montre la fixation par soudure de la masse 21 de l'antenne 20 du terminal sur la face 28 du circuit imprimé 26 opposée à la face 30 du circuit imprimé 26 sur laquelle est soudé l'amplificateur de puissance 24. La puissance thermique est dissipée via des ponts thermiques, par exemple, des trous métallisés 32 réalisé entre les deux faces 28 et 30 du circuit imprimé.

De plus, aucun élément supplémentaire n'est ajouté au dispositif existant pour la dissipation la puissance thermique générée par l'amplificateur de puissance 24.

Enfin, le dispositif peut être assemblé pendant la fabrication sans intervention ultérieure.

## Revendications

1. Dispositif de radiocommunication comprenant une antenne (20) et un amplificateur de puissance (24) relié à un circuit imprimé (26), **caractérisé en ce que** la masse (21) de l'antenne (20) et la masse (22) de l'amplificateur de puissance (24) sont reliée thermiquement.

2. Dispositif selon la revendication précédente, **caractérisé en ce que** la masse (21) de l'antenne (20) est fixée entre la masse (22) de l'amplificateur de puissance (24) et le circuit imprimé (26).

3. Dispositif selon la revendication 1, **caractérisé en ce que** la masse (21) de l'antenne (20) est fixée sur la face (28) du circuit imprimé (26) opposé à la face (30) où est fixée la masse (22) de l'amplificateur de puissance (24), la masse (21) de l'antenne (20) étant reliée thermiquement à la masse (22) de l'amplificateur de puissance (24).

4. Dispositif selon la revendication 3, **caractérisé en ce que** la masse (21) de l'antenne (20) est reliée thermiquement à la masse (22) de l'amplificateur de puissance (24) par des ponts thermiques.

5. Dispositif selon l'une des revendications 3 ou 4, **caractérisé en ce que** la masse (21) de l'antenne (20) est reliée thermiquement à la masse (22) de l'amplificateur de puissance (24) par des trous métallisés (32) traversant le circuit imprimé (26).
